(19) Europäisches Patentamt
European Patent Office
Office européen des brevets

(11) **EP 2 107 590 A2**

(12) **EUROPEAN PATENT APPLICATION**

(43) Date of publication:
**07.10.2009 Bulletin 2009/41**

(51) Int Cl.:
*H01J 37/153* (2006.01)  *H01J 37/26* (2006.01)

(21) Application number: **09002873.9**

(22) Date of filing: **27.02.2009**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **31.03.2008 JP 2008092691**

(71) Applicants:
• **Hitachi Ltd.**
**Chiyoda-ku**
**Tokyo 100-8280 (JP)**

• **Okinawa Institute of Science and Technology Promotion Corporation**
**Kunigami-gun**
**Okinawa 904-0411 (JP)**

(72) Inventors:
• **Yoshida, Takaho**
**Tokyo 100-8220 (JP)**
• **Hirayama, Yoichi**
**Tokyo 100-8220 (JP)**

(74) Representative: **Strehl Schübel-Hopf & Partner**
**Maximilianstrasse 54**
**80538 München (DE)**

(54) **Aberration corrector for transmission electron microscope**

(57) To provide an aberration corrector (2) that guarantees freedom in designing a coma-free plane transfer portion even when the mechanical configuration of the aberration corrector is already decided, and has a flexible adjustment margin regarding the corrector exterior. The aberration corrector causes an electron beam trajectory emanating from a specimen plane (3,15) (physical surface of objective lens) to be incident in parallel with a multipole lens (HEX1 18), and causes an electron beam trajectory emanating from an objective-lens coma-free plane (16) or a minimum plane of a fifth-order aberration (objective lens center) to form an image on a center plane of a multipole lens of the 4f system. Thus, antisymmetric transfer is performed between two multipole lenses (HEX1 18, HEX2 19) to correct a spherical aberration in the 4f system, and a coma-free plane or a minimum plane of a fifth-order aberration is transferred to suppress occurrence of coma aberrations or fifth-order aberrations.

FIG. 1

**Description**

CLAIM OF PRIORITY

The present application claims priority from Japanese patent application JP 2008-092691 filed on March 31, 2008, the content of which is hereby incorporated by reference into this application.

BACKGROUND OF THE INVENTION

Field of the Invention

The present invention relates to a charged particle beam apparatus, and more particularly to an aberration corrector used in a transmission electron microscope.

Background Art

Theoretically, spherical aberrations of electron lenses that use rotationally symmetric electromagnetic fields are always a positive value, and even by compensating for a spherical aberration within a range in which these are used, it is not possible to make the spherical aberration 0. Accordingly, until recently spherical aberration had been the biggest factor limiting the resolution of electron microscope apparatuses.

In contrast, from the latter part of the 1990's, practical application of spherical aberration correctors using non-rotationally symmetric electron optical systems such as multipole lens has been proceeded. Currently, in 2008, at the practical use level, electron microscopes mounted with spherical aberration correctors are been manufactured commercially. In particular, for transmission electron microscopes (TEM) having an accelerating voltage exceeding 100 kV, in many cases the spherical aberration is the biggest factor that determines the resolution, and the effect of utilizing a spherical aberration corrector is significant.

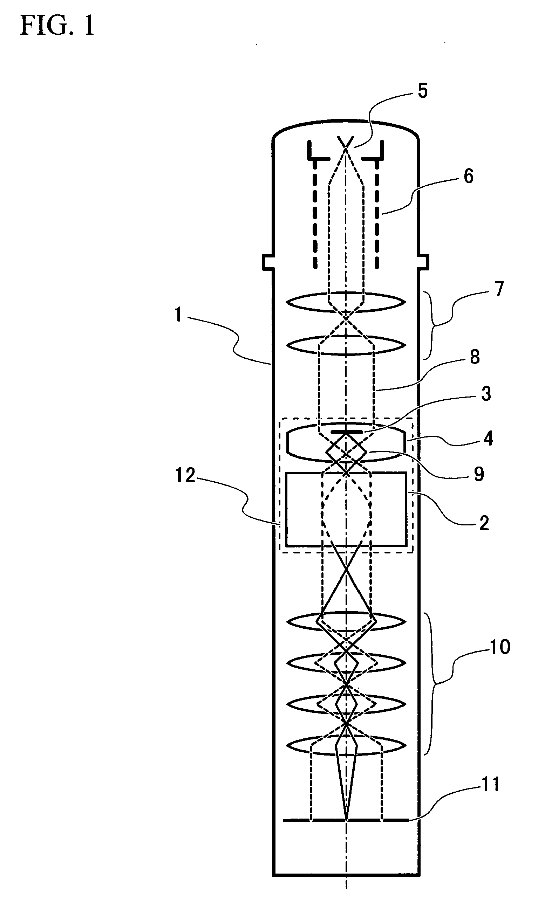

FIG. 1 is a view that illustrates the outline of a TEM that is equipped with an aberration corrector. In a TEM mirror body 1, a spherical aberration corrector 2 is disposed downstream from a specimen 3 in a condition in which an objective lens 4 is sandwiched between the spherical aberration corrector 2 and the specimen 3. The principal purpose of the spherical aberration corrector 2 is to correct a spherical aberration of the objective lens 4. The specimen 3 is irradiated with an electron beam 8. The electron beam 8 is obtained from an electron source 5 (electron sources according to a thermoelectronic emission method, a field emission method, a thermal-field emission method and the like are available), accelerated with a predetermined accelerating voltage in an accelerating tube 6, and thereafter the degree of convergence of the electron beam 8 is adjusted using one or more condensing lenses 7. At this time, an electron beam 9 that is scattered at the specimen 3 is formed into an image with the objective lens 4 to obtain a magnified image. When attempting to observe the specimen 3 at a high resolution of 1 nm or less, normally the specimen 3 is arranged in a position in which it is immersed in the magnetic field of the objective lens polepiece (magnetic pole for concentrating a magnetic field), and hence the illustration in FIG. 1 shows the specimen 3 as being placed inside the objective lens 4.

In the process of forming a magnified image, the spherical aberration corrector 2 is arranged directly below the objective lens 4 and compensates for image distortion or blurring that occurs due to a spherical aberration of the objective lens 4. The obtained magnified image is magnified further at a plurality of image-forming lenses 10 that are arranged further downstream, to thereby form an image on an observation surface 11. Normally, a fluorescent screen that is illuminated by the electron beam 8 is arranged on the observation surface, and the magnified image can be observed by viewing this directly. It is also possible to capture an image of the magnified image using a film or CCD camera. In this connection, FIG. 1 illustrates a basic configuration, and other auxiliary devices such as an astigmatic corrector or a deflector that adjusts an electron beam are omitted from the description.

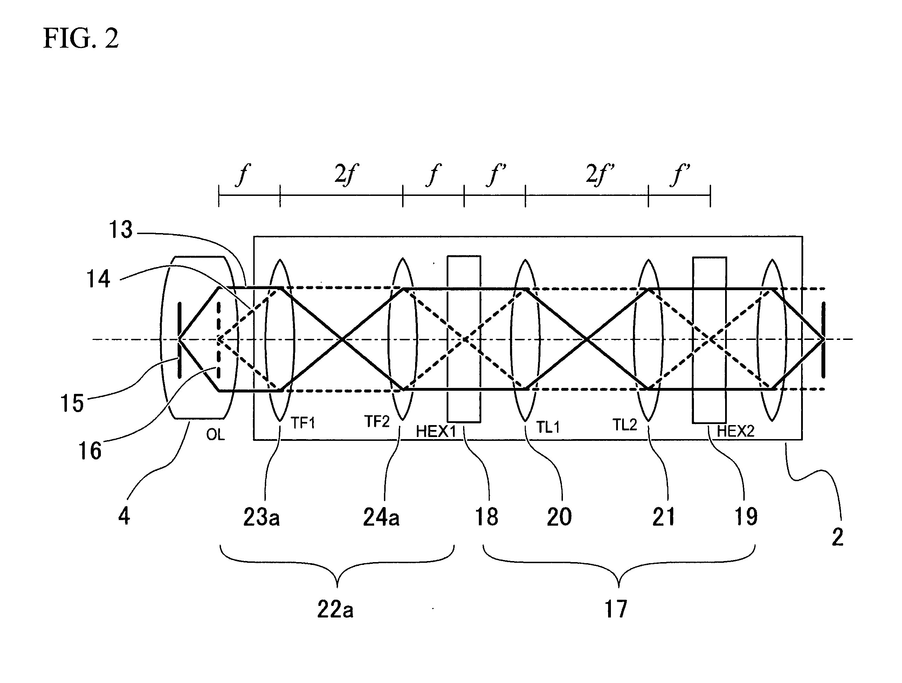

In the aforementioned TEM, as a spherical aberration corrector that is appropriate for performing a spherical aberration correction, a configuration including two hexapole lenses that is proposed by H. Rose in JP Patent No. 3207196 (hereunder, referred to as "Patent Document 1") is currently being practically applied by M. Haider et al. FIG. 2 is a view that illustrates the configuration of the area indicated by a broken-line frame 12 in FIG. 1 that includes the specimen 3, the objective lens 4, and the spherical aberration corrector. In FIG. 2, a solid line 13 and a broken line 14 denote electron beam trajectories that emanate from a specimen plane 15 and a coma-free plane 16 (described later), respectively. In FIG. 2, the left side is illustrated as the upstream region of the electron microscope, and thus the objective lens 4 and the specimen 3 are shown at the left end in FIG. 2. The corrector 2 is disposed on the lower side (right side in FIG. 2) of the objective lens 4 and the specimen 3. The corrector 2 is broadly divided into a first half portion extending from directly below the objective lens 4 to the front of the first hexapole lens 18, and the latter half portion below the first half portion. The latter portion is a spherical aberration correction portion (referred to as "4f system 17" by H. Rose) that corrects a spherical aberration of the objective lens 4. The spherical aberration correction portion includes two hexapole lenses HEX1 18 and HEX2 19, and two rotationally symmetric transfer lenses TL1 20 and TL2 21 that are sandwiched by the two hexapole lenses HEX1 18 and HEX2 19.

Although it is known that the hexapole lens 18 has a negative spherical aberration, an aberration such as a three-fold symmetry astigmatic aberration that is unnecessary for correction is also generated at the same time. In such case, it is possible to cancel the three-fold symmetry astigmatic aberration by preparing two of the hexapole lenses 18 and 19 and performing an antisymmetric transfer with the transfer lenses 20 and 21, to thereby extract only a negative spherical aberration (the astigmatic aberration is cancelled by lenses 20 and 21). An adjustment is performed so as to offset the size of the negative spherical aberration with a positive spherical aberration of the objective lens 4 to implement a spherical aberration correction. To establish appropriate transfer conditions, it is necessary to arrange HEX1 18, HEX2 19, TL1 20, and TL2 21 of the 4f system at the lengths f, 2f, and f as shown in FIG. 2 based on the focal length f of the transfer lenses.

In contrast, the first half portion is designed to suppress a first off-axis aberration, that is, a coma aberration, which constitutes the next problem after a spherical aberration in a TEM. A coma-free transfer is realized between the objective lens and the 4f system using the two transfer lenses included in the first half portion. Hereunder, the first half portion is referred to as "coma-free plane transfer portion 22".

A coma-free plane 16 (plane where coma aberration coefficient becomes 0 in polarity inversion process) of the objective lens 4 itself is formed in the vicinity of a back focal plane of the objective lens 4. The coma-free plane 16 of the objective lens 4 is transferred to the center plane of HEX1 18 as the coma-free plane of the 4f system using the two transfer lenses TF1 23a and TF2 24a, to suppress an increase in the coma aberration. In this connection, in order to perform this transfer in a 1:1 ratio, H. Rose stipulates that the lenses in the coma-free plane transfer portion should be disposed at lengths f, 2f, and f as shown in FIG. 2, taking the focal length of the transfer lenses as f (see Patent Document 1).

However, when a condition for disposing lenses in the coma-free plane transfer portion 22 does not comply with the above described 1:1 transfer condition, it is possible to perform a coma-free transfer even outside the restrictive condition of Rose. Conversely, by performing a transfer by imparting a magnification, and not as a 1:1 transfer, there is also the advantage that the effect of the aberration corrector can be adjusted. By focusing on this point, M. Haider et al. disclose a configuration of an improved spherical aberration corrector in JP Patent Publication (Kohyo) No. 2002-510431 B (hereunder, referred to as "Patent Document 2").

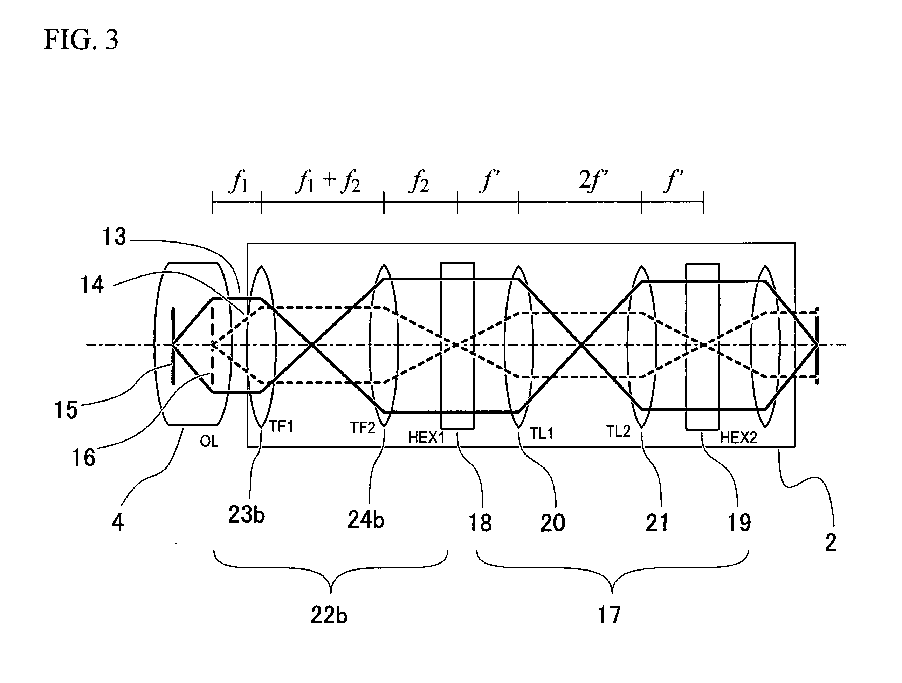

FIG. 3 illustrates the configuration of the spherical aberration corrector according to Haider. As shown in FIG. 3, the latter half 4f portion of the corrector is the same as in the configuration of H. Rose shown in FIG. 2. However, the disposition of lenses in the coma-free plane transfer portion is changed so that the TF1 23b and the TF2 24b have differing focal lengths f1 and f2. The respective lenses in the coma-free plane transfer portion at this time are disposed at lengths $f_1$, $f_1+f_2$, and $f_2$. A magnitude $m_t$ at the transfer lenses TF1 23b and TF2 24b in the coma-free plane transfer portion at this time is represented by the following expression:

[Expression 1]

$$ m_t = \frac{f_1}{f_2} \qquad \cdots \quad (1) $$

In this connection, in the configuration according to H. Rose shown in FIG. 2, $f_1 = f_2$, that is, $m_t = 1$.

At this time, considering the physical surface of the objective lens, offsetting of a spherical aberration at the spherical aberration corrector and the objective lens is represented by the following expression:

[Expression 2]

$$ C_{so} + (m_o m_t)^{-4} C_{sc} \equiv 0 \qquad \cdots \quad (2) $$

Here, $C_{SO}$ denotes a spherical aberration (coefficient) of the objective lens, $C_{SC}$ denotes a spherical aberration of the spherical aberration corrector, and $m_O$ denotes the magnitude of the objective lens. For example, if $m_t<1$ assuming that $f_1<f_2$, the spherical aberration $C_{SO}$ of the objective lens 4 can be offset with a smaller correction amount ($C_{SC}$). Thus, a spherical aberration correction can be adjusted using $m_t$ in this manner.

[Non-Patent Document 2] "Upper limits for the residual aberrations of a high- resolution aberration-corrected STEM", M. Haider, S. Uhlemann, J. Zach, Ultramicroscopy vol. 81, p.163, (2000)

[Non-Patent Document 2] "Towards sub-0.5 A electron beams", O. L. Krivanek, P. D. Nellist, N. Dellby, M. F. Murfitt, Z. Szilagyi, Ultramicroscopy vol. 96, p. 229, (2003)

SUMMARY OF THE INVENTION

However, with both the configuration according to H. Rose shown in FIG. 2 and the configuration according to M. Haider shown in FIG. 3, the disposition of lenses in the coma-free plane transfer portion is fixed, and the disposition is restricted by the focal lengths of the respective transfer lenses that are used (f according to the configuration of H. Rose, and $f_1$ and $f_2$ according to the configuration of M. Haider). More specifically, in the configuration of H. Rose, f is fixed by the mechanical configuration of the coma-free plane transfer portion, and in the configuration of M. Haider, although $f_1$ includes some degree of flexibility, when $f_1$ and the mechanical configuration of the coma-free plane transfer portion are decided, $f_2$ is decided. This is a restriction (that deprives the apparatus design of flexibility) at the time of considering the specific apparatus configuration.

Further, the problem that fine adjustment is difficult after assembling the apparatus also arises. More specifically, in the case of both H. Rose and M. Haider, because the optical conditions of the coma-free plane transfer portion are fixed once the apparatus configuration has been decided, for example, in a case in which the coma-free plane of the objective lens is displaced from the design position, or when there is no adjustment margin when attempting to change a usage condition of the objective lens such as the magnification or the specimen position from an initial value in accordance with the observation requirements, strictly speaking, the positions of TF1 and TF2 must be shifted in accordance with the displacement from the design values or with the desired optical conditions.

Further, as described in the foregoing, according to the configuration of M. Haider shown in FIG. 3 it is possible to impart a magnification at the coma-free plane transfer portion 22 and adjust the balance of offsetting the objective lens spherical aberration with a spherical aberration of the corrector by the method of expression 2. However, if $f_1$ and $f_2$ are fixed, then $m_t$ also has a constant value and does not serve as a parameter that can be adjusted in an operating state (although it may be an adjustment parameter at the stage of designing the aberration corrector). With regard to the aberration corrector, there are times when it is necessary to finely adjust a spherical aberration of the aberration corrector in an adjustment process to suppress a parasitic aberration or an aberration of a higher order than a third-order aberration that is ascribable to an imperfection of the corrector itself. Conventionally, according to the correctors of H. Rose shown in FIG. 2 and M. Haider shown in FIG. 3, these problems have been dealt with by directly altering $C_{SC}$. This means sequentially changing the strength of hexapole lenses HEX1 and HEX2 inside the 4f system in accordance with fine adjustment of the aberration corrector. However, a high accuracy is required to combine the mutual axes of the hexapoles, and a change in excitation is liable to cause an axial displacement. Therefore, after finding conditions that are nearest to the appropriate ones, it is desirable to use the apparatus with the conditions fixed as they are with as little movement as possible. If it is possible to keep $m_t$ in expression 2 as a variable adjustment parameter even in the adjustment process, it is convenient for the 4f system since $m_t$ in a transfer lens portion (comprising a spherical lens that is easy to adjust) can be changed while the conditions are kept fixed so that the spherical aberration correction balance represented by expression 2 can be adjusted.

As described above, in the spherical aberration correctors proposed heretofore, the disposition of lenses is restricted and fixed because of conditions that are necessary for a spherical aberration correction, and thus the degree of freedom in designing a specific apparatus configuration has been limited. Further, after assembling an aberration corrector, the disposition of lenses is fixed and there is no margin left for adjustment. Accordingly in a state in which a corrector is actually being used it is difficult to make an adjustment to the corrector in order to, for example, rectify an error between the design and the manufactured corrector or to correspond to an adjustment according to the actual conditions of use. In particular, since it is difficult to perform a fine adjustment with the 4f system, it is considered that, rather, it is more suitable to use the corrector with fixed conditions. On the other hand, with respect to the coma-free plane transfer portion in the first half of the corrector, it is also considered suitable to provide a flexible adjustment margin with respect to the corrector exterior in order to maintain fixed conditions of the 4f system. For example, as described above, if the transfer magnification $m_t$ in the coma-free plane transfer portion 22 can be made variable, by changing $m_t$ while keeping the conditions fixed without performing a complicated adjustment of the 4f system such as a hexapole lens adjustment, it is also possible to finely adjust the offsetting between the spherical aberrations of the corrector and the objective lens 4.

The present invention was made in view of the above described circumstances, and an object of the invention is to provide an aberration corrector that has a flexible adjustment margin with respect to the corrector exterior and that guarantees a degree of freedom in the design of a coma-free plane transfer portion even when the mechanical configuration of the aberration corrector has been already decided.

To solve the above described problems, an aberration corrector according to the present invention causes an electron beam trajectory that emanates from a specimen plane (physical surface of an objective lens) to be incident parallel to a multipole lens (HEX1 18), and causes an electron beam trajectory that emanates from an objective lens coma-free plane or a minimum plane of a fifth-order aberration (center of objective lens) to form an image on a center plane of a multipole lens of the 4f system. As a result, to perform a spherical aberration correction with the 4f system, an antisymmetric transfer is performed between two multipole lenses (HEX1 18, HEX2 19), and transfer of a coma-free plane or a minimum plane of a fifth-order aberration is performed to suppress the occurrence of a coma aberration or a fifth-order aberration.

More specifically, an aberration corrector according to the present invention is an aberration corrector for a transmission electron microscope that is disposed downstream of an objective lens of a transmission electron microscope and that performs a spherical aberration correction by offsetting a spherical aberration of the objective lens with a negative spherical aberration that is generated at a combination lens including a plurality of multipole lens, comprising: a spherical aberration correction portion that generates a negative spherical aberration; and a transfer portion that is provided between the objective lens and the spherical aberration correction portion and that has a first and a second spherical transfer lens that suppress an occurrence of a coma aberration or a fifth-order aberration. The transfer portion transfers a coma-free plane or a minimum plane of a fifth-order aberration of the objective lens that is formed in the vicinity of a back focal plane of the objective lens to a coma-free plane of the spherical aberration correction portion or a center plane of a first lens (multipole lens located at an upstream position) of the spherical aberration correction portion, and causes an electron beam that is scattered at a specimen and emanates from a specimen plane to be incident in parallel with the spherical aberration correction portion. Further, among the two spherical transfer lenses of the coma-free plane transfer portion, a length between the objective lens and the first spherical transfer lens that is arranged at a nearest position to the objective lens is different to a focal length of the first spherical transfer lens.

Further, an aberration corrector according to the present invention is an aberration corrector for a transmission electron microscope that is disposed downstream of an objective lens of a transmission electron microscope and that performs a spherical aberration correction by offsetting a spherical aberration of the objective lens with a negative spherical aberration that is generated at a combination lens including a plurality of multipole lens, comprising: a spherical aberration correction portion that generates a negative spherical aberration; and a transfer portion that is provided between the objective lens and the spherical aberration correction portion and that has a first, a second, and a third spherical transfer lens that suppress an occurrence of a coma aberration or a fifth-order aberration, and that enables an adjustment of a transfer magnification to the spherical aberration correction portion from the objective lens by means of the spherical transfer lenses. The transfer portion transfers a coma-free plane or a minimum plane of a fifth-order aberration of the objective lens that is formed in the vicinity of a back focal plane of the objective lens to a coma-free plane of the spherical aberration correction portion or a center plane of a first lens (multipole lens located at an upstream position) of the spherical aberration correction portion, and causes an electron beam that is scattered at a specimen and emanates from a specimen plane to be incident in parallel with the spherical aberration correction portion. Further, among the three spherical transfer lenses of the transfer portion, a length between the objective lens and the first spherical transfer lens that is arranged at a nearest position to the objective lens is different to a focal length of the first spherical transfer lens.

Other features of the present invention will be apparent from the preferred embodiments of the invention that are described below and from the attached drawings.

According to the present invention, it is possible to guarantee a degree of freedom in the design of a coma-free plane transfer portion even when the mechanical configuration of an aberration corrector has been already decided, and to provide a flexible adjustment margin with respect to the corrector exterior.

BRIEF DESCRIPTION OF THE DRAWINGS

FIG. 1 is a view that illustrates the configuration of a transmission electron microscope mirror including a spherical aberration corrector.

FIG. 2 is a view that illustrates the configuration of a conventional aberration corrector for a transmission electron microscope (Rose).

FIG. 3 is a view that illustrates the configuration of a conventional aberration corrector for a transmission electron microscope (Haider).

FIG. 4 is a view that illustrates the configuration of an aberration corrector according to a first embodiment of the present invention.

FIG. 5 is a view that illustrates focal lengths of a transfer lens group and a transfer magnification as advantages of the aberration corrector according to the first embodiment.

FIG. 6 is a view that illustrates the configuration of an aberration corrector according to a second embodiment of the present invention.

FIG. 7 is a view that illustrates the relationship between focal lengths of a transfer lens group and a transfer magnification as advantages of the aberration corrector according to the second embodiment.

FIG. 8 is a view that illustrates actual application conditions of an aberration corrector according to the second embodiment of the present invention.

DESCRIPTION OF SYMBOLS

| | |
|---|---|
| 1 | Transmission electron microscope mirror body including spherical aberration corrector |
| 2 | Spherical aberration corrector for transmission electron microscope |
| 3 | Specimen that is observed |
| 4 | Objective lens |
| 5 | Electron source |
| 6 | Accelerating tube |
| 7 | Converging lens (group) |
| 8 | Electron beam that irradiates specimen |
| 9 | Electron beam scattered at specimen |
| 10 | Projection lens (group) |
| 11 | Observation surface |
| 12 | Objective lens and aberration corrector |
| 13 | Paraxial trajectory of electron beam emitted from specimen plane on optical axis |
| 14 | Paraxial trajectory of electron beam emitted from coma-free plane of objective lens on optical axis |
| 15 | Specimen |
| 16 | Coma-free plane of objective lens |
| 17 | 4f system |
| 18 | Hexapole lens 1 (HEX1) |
| 19 | Hexapole lens 2 (HEX2) |
| 20 | Transfer lens 1 (TL1) inside 4f system |
| 21 | Transfer lens 2 (TL2) inside 4f system |
| 22a | Coma-free plane transfer portion of H. Rose |
| 22b | Coma-free plane transfer portion of M. Haider |
| 22c | Coma-free plane transfer portion according to first embodiment |
| 22d | Coma-free plane transfer portion according to second embodiment |
| 23 a | Transfer lens 1 (TF1) inside coma-free plane transfer portion of H. Rose |
| 23b | Transfer lens 1 (TF1) inside coma-free plane transfer portion of M. Haider |
| 23c | Transfer lens 1 (TF1) inside coma-free plane transfer portion according to first embodiment |
| 23d | Transfer lens 1 (TF1) inside coma-free plane transfer portion according to second embodiment |
| 24a | Transfer lens 2 (TF2) inside coma-free plane transfer portion of H. Rose |
| 24b | Transfer lens 2 (TF2) inside coma-free plane transfer portion of M. Haider |
| 24c | Transfer lens 2 (TF2) inside coma-free plane transfer portion according to first embodiment |
| 24d | Transfer lens 2 (TF2) inside coma-free plane transfer portion according to second embodiment |

DETAILED DESCRIPTION OF THE PREFERRED EMBODIMENTS

An object of the present invention is to improve the resolution in a charged particle beam apparatus. In particular, the present invention relates to an apparatus that compensates for a spherical aberration in a transmission electron microscope. Similarly to the prior art, an aberration corrector according to the present invention can be applied to the charged particle beam apparatus (transmission electron microscope apparatus) shown in FIG. 1.

Hereunder, embodiments of the present invention are described with reference to the attached drawings. However, the following embodiments are merely examples for implementing the present invention, and it should be noted that these embodiments do not limit the technical scope of the present invention. Common components are denoted by the same reference numerals in the drawings.

<First embodiment>

First, the principles of the present invention will be described.

The lens configuration of a coma-free plane transfer portion that can provide an adjustment margin in order to, for example, rectify an error between a design and a manufactured corrector or to correspond to an adjustment according to actual usage conditions while maintaining the coma-free plane transfer conditions is described below. First, the coma-free plane transfer conditions are compiled below.

Condition 1: An electron beam trajectory 13 emanating from a specimen plane (physical surface of objective lens) is caused to be incident in parallel with the HEX1 18. (The electron beam trajectory in question corresponds to the trajectory of an electron beam that is scattered from the specimen. This is a necessary condition for performing an antisymmetric transfer between the HEX1 18 and the HEX2 19 in order to perform a spherical aberration correction in a 4f system 17).

Condition 2: An electron beam trajectory 14 emanating from an objective-lens coma-free plane 16 forms an image on a 4f-system coma-free plane (center plane of HEX1 18). (This is a necessary condition for performing a coma-free transfer to suppress the generation of a coma aberration.)

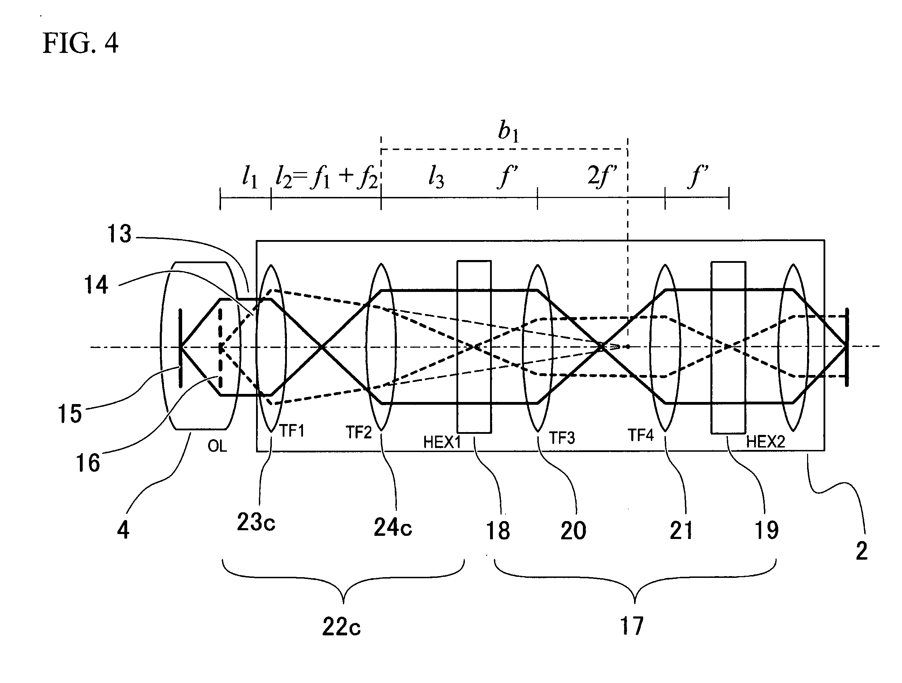

FIG. 4 illustrates the configuration of an aberration corrector that is based on conditions 1 and 2 above. The relational expression for conditions 1 and 2 is as follows:

[Expression 3]

$$\begin{cases} l_2 = f_1 + f_2 \\ l_3 = b_2 \end{cases} \qquad \cdots \quad (3)$$

Here, $l_1$, $l_2$, and $l_3$ denote lengths between the objective lens and TF1, TF1 and TF2, and TF2 and HEX1, respectively, as shown in each drawing. Further, $f_1$, and $f_2$ denote the focal lengths of TF1 23c and TF2 24c, respectively. $b_2$ denotes a length from the relevant lens as far as a plane at which the TF2 24c transfers the coma-free plane 16, taking the electron trajectory of condition 2 into consideration, and is represented by the following relation based on the formula of the lens using the aforementioned $l_1$, $l_2$, and $l_3$, and $f_1$ and $f_2$.

[Expression 4]

$$\frac{1}{f_2} = \frac{1}{l_2 - b_1} + \frac{1}{b_2} \qquad \text{i. e.} \qquad b_2 = -\frac{f_2(l_2 - b_1)}{f_2 - (l_2 - b_1)} \quad \cdots (4)$$

Provided, $b_1$ denotes a length from the TF1 23c to an intermediate transfer plane of the coma-free plane.

[Expression 5]

$$\frac{1}{f_1} = \frac{1}{l_1} + \frac{1}{b_1} \qquad \text{i. e.} \quad b_1 = -\frac{f_1 l_1}{f_1 - l_1} \qquad \cdots (5)$$

By combining expression 3, expression 4, and expression 5 to solve $f_1$ and $f_2$, expression 6 is established.

[Expression 6]

$$f_1 = \frac{l_2(2l_1 + l_2 \pm K)}{2L} \qquad \cdots \quad (6)$$

$$f_2 = \frac{l_2(2l_3 + l_2 \mp K)}{2L}$$

Provided, $L_t$ is the entire length of the coma-free plane transfer portion 22, that is, expression 7.

## [Expression 7]

$$L_t = l_1 + l_2 + l_3 \quad \cdots \quad (7)$$

Further, K is a parameter represented by expression 8 below.

## [Expression 8]

$$K = \sqrt{l_2^2 - 4l_1l_3} \quad \cdots \quad (8)$$

That is, the solution represented by expression 6 is a real solution in a range in which K is a real number, that is, in a case in which expression 9 is satisfied.

## [Expression 9]

$$l_2 > 2\sqrt{l_1 l_3} \quad \cdots \quad (9)$$

Naturally, $l_1$, $l_2$, and $l_3$ are positive numbers, and in a range in which expression 9 has a solution with a simple operation, $f_1$ and $f_2$ of expression 6 can also be shown to be positive values.

The foregoing description shows that, while satisfying conditions relating to the coma-free plane transfer portion 22 of conditions 1 and 2, focal lengths $f_1$ and $f_2$ of the TF 1 and TF2 that are effective for arbitrary lens intervals $l_1$, $l_2$, and $l_3$ can be found within a range in which expression 9 has a solution. This result remarkably increases the degree of freedom with respect to the disposition of lenses in the coma-free plane transfer portion at the design stage, and further, after the disposition of lenses has been fixed, it is possible to perform a fine adjustment according to expression 6 even in an operating state.

The addition of a third transfer lens may also be considered to give the coma-free plane transfer portion 22 an adjustable magnification. Using the increased flexibility obtained by addition of a lens, leeway is generated that makes it possible to control the transfer magnification of the coma-free plane transfer portion 22 while maintaining the coma-free plane transfer conditions.

Next, a specific example is given and examined based on the above described principles of the invention. In this case, regarding the configuration shown in FIG. 4, for example, assuming that $l_1$ = 30 mm and $l_3$ = 45 mm, the values shown in expression 9 and expression 10 are determined.

## [Expression 10]

$$l_2 > 30\sqrt{6} \approx 73.5 \, \text{mm} \quad \cdots \quad (10)$$

When $l_2$ is a value in the range shown by expression 10, the coma-free plane transfer portion 22 has a solution according to expression 6 that establishes the aforementioned conditions 1 and 2. In this connection, expression 10 is, for example, represented with an accuracy of ±1%.

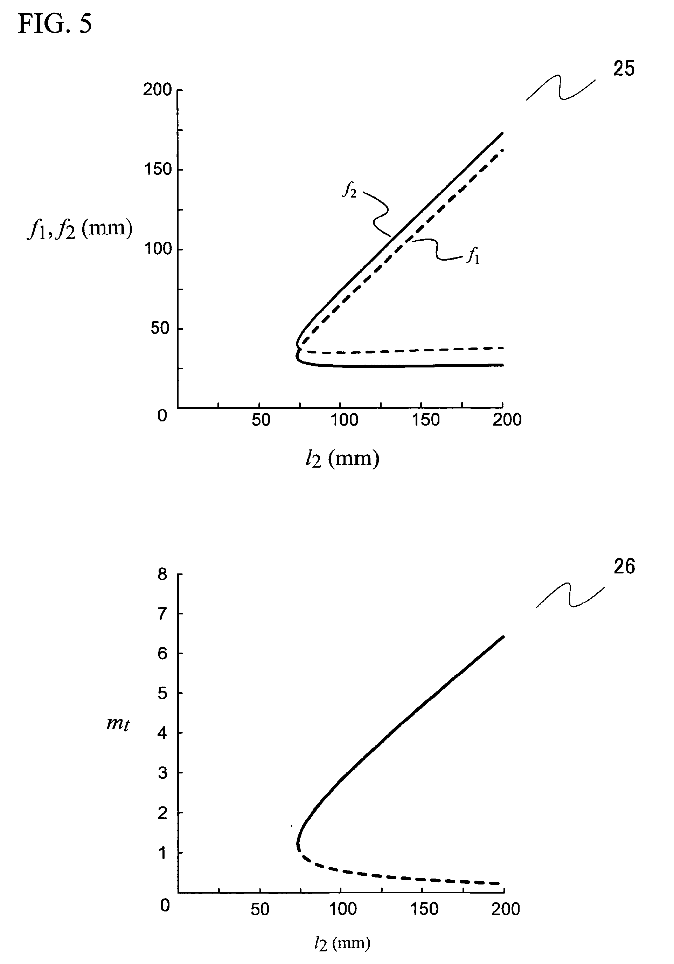

A graph 25 shown in FIG. 5 shows the manner in which $f_1$ and $f_2$ change with $l_1$ as a parameter at this time. A broken line and a solid line in the graph depend on whether the upper symbol or the lower symbol of +/- (plus/minus) and -/+ (minus/plus) in expression 6 is adopted. It is verified that $f_1$ and $f_2$ have a positive number solution within the range of expression 10 for either + or -.

In contrast, as shown in a graph 26 in FIG. 5, the transfer magnification $m_t$ differs greatly according to whether the upper symbol or the lower symbol of +/- and -/+ in expression 6 is adopted. Accordingly, although in practice the combination of $f_1$ and $f_2$ ought to be decided by taking into account this difference in the transfer magnification, normally, in order to obtain an aberration correction more efficiently, it is considered more suitable to select a combination of $f_1$ and $f_2$ such that $m_t$ decreases from expression 2, i.e. a combination of $f_1$ and $f_2$ that adopts + in expression 6. However, even with a combination of $f_1$ and $f_2$ that adopts -, because the coma-free conditions are maintained, by switching these two conditions it is possible to perform a comparative observation with respect to an appropriate spherical aberration correction state and an insufficient correction state by adjusting only the transfer lenses TF1 23 and TF2 24 without touching the 4f system 17. When an observation can be performed by easily switching between an appropriate correction state and an insufficient correction state in this manner, for example, it is possible to confirm the correction status at the stage of adjusting an aberration correction (confirm whether or not an appropriate aberration correction could be executed). Furthermore, it is possible to compensate for a contrast with respect to a long-term structure that, conversely, declines at the time of an appropriate spherical aberration correction by observation of an insufficient correction state. More specifically, when a spherical aberration is corrected, there is a tendency for a large item to become harder to see, although a minute item can be seen clearly. Hence, when it is desired to observe a large item, it is better to select the combination of lower symbols in expression 6 to observe the specimen. By selecting a combination in this manner, it is possible to switch between existence/non-existence of a correction of a spherical aberration while securing a coma free condition. According to the conventional configuration, it is necessary to remove the corrector 2 itself and a coma free condition can not be secured. This is one advantage according to the present invention.

In this connection, a case in which it is assumed that $l_2 = l_1 + l_3 = 75$ mm under the condition shown in the graph is equivalent to the spherical aberration corrector according to M. Haider (see FIG. 3). Further, when it is further assumed that $l_1 = l_3 = l_2/2$, this case is equivalent to the spherical aberration corrector according to H. Rose (see FIG. 2).

Thus, according to the present invention, the condition ($l_2 = l_1 + l_3, l_1 = l_3 = l_2/2$) should be omitted from expression 6, and is summarized as $l_1 \neq f_1, l_3 \neq f_2$.

<Second Embodiment>

As described in the foregoing, since adjustment of the 4f system is difficult, it is desirable that execution of a fine adjustment of a spherical aberration correction is concentrated on transfer lenses of a coma-free plane transfer portion while maintaining the 4f system in a fixed condition. To achieve this, a three-lens configuration is adopted by adding a single lens TF3 24d the transfer lenses that had been a two-lens configuration comprising TF1 and TF2. It is thereby possible to vary the transfer magnification $m_t$ in a zooming manner while maintaining the coma-free transfer conditions. That is, the degree of freedom in setting a transfer magnification can also be increased.

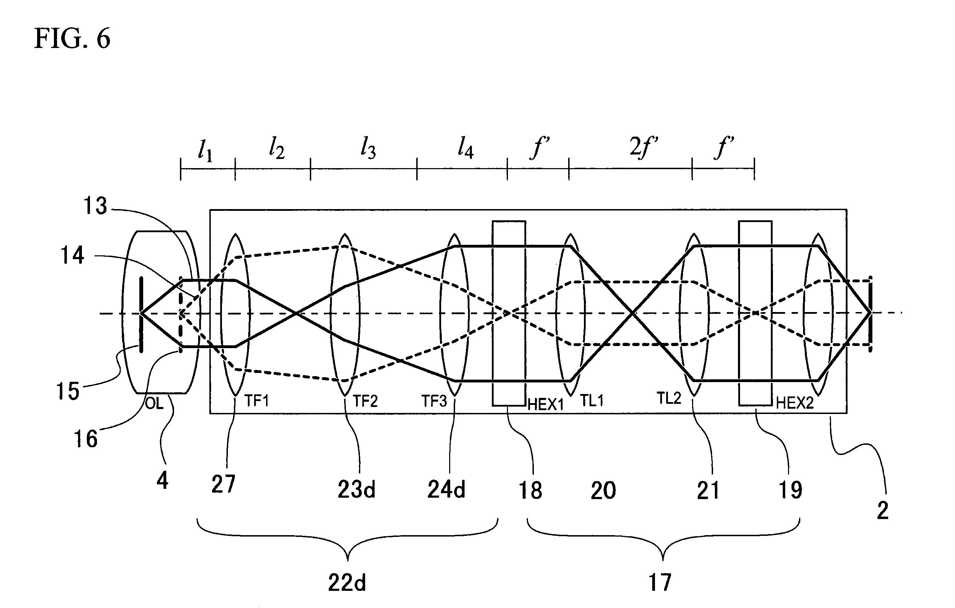

According to the second embodiment, as shown in FIG. 6, the coma-free plane transfer portion 22 comprises lenses in the order of TF1 27 TF2 23d and TF3 24d between the objective lens 4 and the first hexapole lens 18 of the 4f system. In this case, focal lengths $f_1$, $f_2$, and $f_3$ that satisfy the above described conditions 1 and 2 are given by expression 11.

[Expression 11]

$$f_1 = \frac{l_2\left(l_1 m_t^2 + l_4\right)}{(l_1 + l_2)m_t^2 - l_3 m_t + l_4} = L\frac{k_3\left(m_t^2 + k_4\right)}{m_t^2 - k_2 m_t + (k_3 + k_4)}$$

$$f_2 = -\frac{l_2 l_3 m_t}{l_1 m_t^2 - (l_2 + l_3)m_t + l_4} = -L\frac{k_2 k_3 m_t}{m_t^2 - (k_2 + k_3)m_t + k_4} \quad \cdots \quad (11)$$

$$f_3 = \frac{l_3\left(l_1 m_t^2 + l_4\right)}{l_1 m_t^2 - l_2 m_t + (l_3 + l_4)} = L\frac{k_2\left(m_t^2 + k_4\right)}{(1 + k_2)m_t^2 - k_3 m_t + k_4}$$

Provided, it is assumed that the lengths between the objective lens 4 and TF1 27, TF1 27 and TF2 23d, TF2 23d and TF3 24d, and TF3 24d and HEX1 18, are $l_1$, $l_2$, $l_3$, and $l_4$, respectively, and the second term in each expression is given as follows taking $l_1 \equiv L$ as a reference.

[Expression 12]

$$l_1 \equiv L$$
$$l_2 = k_2 L$$
$$l_3 = k_3 L \qquad \cdots \qquad (12)$$
$$l_4 = k_4 L$$

As shown in expression 11, since $m_t$ can be left as an independent variable, it is possible to adjust the transfer magnification $m_t$ while maintaining the coma-free transfer conditions. Further, when each of the lenses are arranged at regular intervals (that is, when $l_1 = l_2 = l_3 = l_4 \equiv L$), $f_1$, $f_2$, and $f_3$ are given by expression 13.

[Expression 13]

$$f_1 = L \frac{\left(1 + m_t^2\right)}{m_t^2 - m_t + 2}$$

$$f_2 = -L \frac{m_t}{\left(m_t - 1\right)^2} \qquad \cdots \qquad (13)$$

$$f_3 = L \frac{\left(1 + m_t^2\right)}{2m_t^2 - m_t + 1}$$

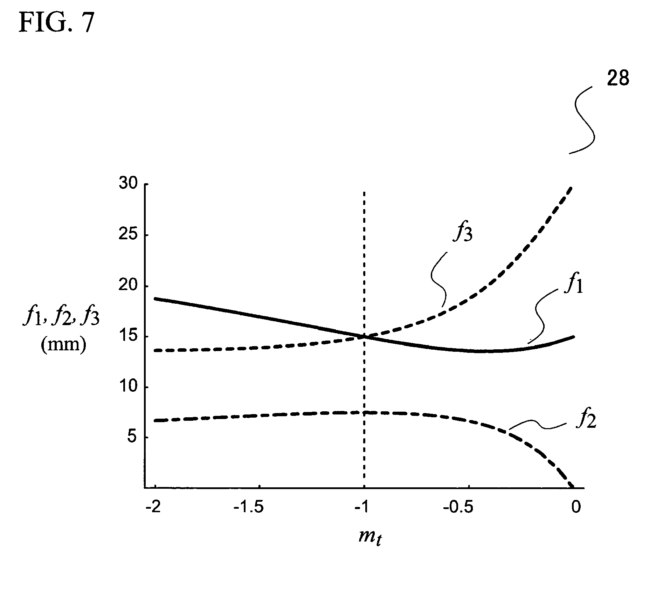

According to expression 13, a positive number solution can be found for $f_1$, $f_2$, and $f_3$ when $m_t < 0$. As an example, the relation when L = 30 mm (expression 13) is plotted in a graph 28 of FIG. 7. In particular, in order to finely adjust the magnification, when the behavior in the vicinity of $|m_t| \approx 1$ (in this case, $m_t \approx -1$) is expanded and viewed at this point, $f_1$, $f_2$, and $f_3$ are each given by expression 14.

[Expression 14]

$$f_1 = \frac{L}{2} \left\{ 1 + \frac{\delta m}{4} \right\} + O\left(\delta m^2\right)$$

$$f_2 = \frac{L}{4} + O\left(\delta m^2\right) \qquad \cdots \qquad (14)$$

$$f_3 = \frac{L}{2} \left\{ 1 - \frac{\delta m}{4} \right\} + O\left(\delta m^2\right)$$

Provided, when it is assumed that $m_t \equiv \delta m_t - 1$, and $O(\delta m^2)$ is a term that is equal to or greater than the square of $\delta m$, the influence when $\delta m \ll 4/5$ is small. Accordingly, as an adjustment operation when $\delta m$ is in the above range, first, in order to obtain $m_t = -1$, expression 15 is taken as the reference state.

[Expression 15]

$$f_1 = L/2$$
$$f_2 = L/4 \qquad \cdots \qquad (15)$$
$$f_3 = L/2$$

Since $f_2$ changes only in the second order or higher with respect to $\delta m$, it is found that it is sufficient that $f_1$ and $f_3$ are deflected to their respective antisymmetries for every $\delta m/4$ at TF1 23d and TF3 27 while TF2 24d remains fixed. Thus, by applying a condition (arranging lenses at regular intervals) to expression 13 to simplify the expression so as to obtain expression 14, the adjustment operation is simplified.

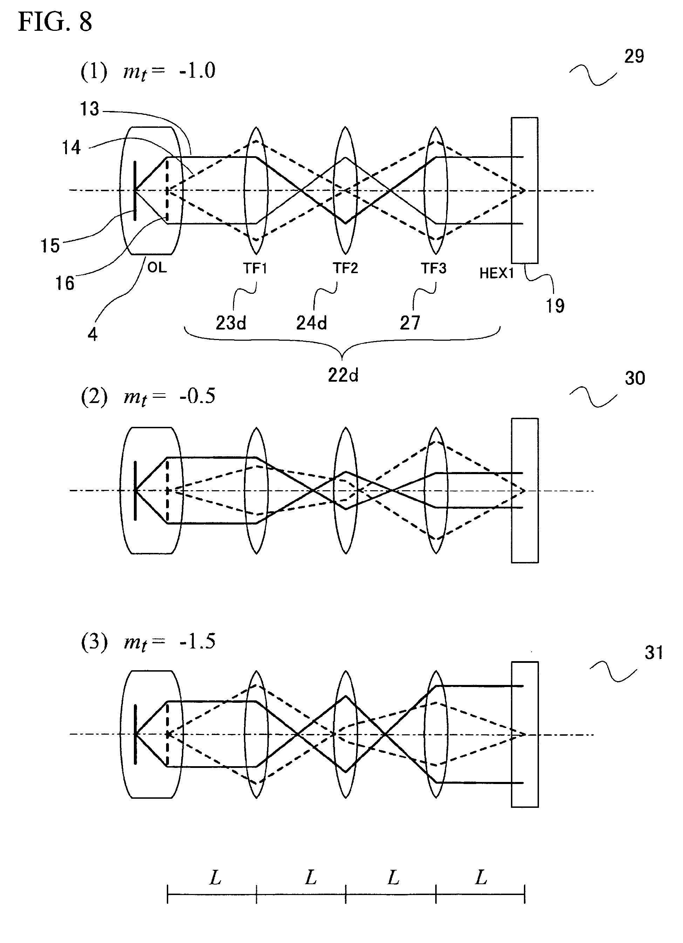

The electron beam trajectory in the reference state that results in $m_t$ = -1 is shown in the drawing denoted by reference number 29 in FIG. 8, and the electron beam trajectories when $m_t$ = -0.5 and $m_t$ = -1.5 are shown in the drawings denoted by reference numbers 30 and 31, respectively, in FIG. 8. Table 1 shows the value of each parameter at this time. As will be understood from FIG. 8, because $m_t$ can not be considered minute when $m_t$ = 0.5, Table 1 is as follows.

[Table 1]

|  | $m_t$ | $f_1$ (mm) | $f_2$ (mm) | $f_3$ (mm) | $t_1$ (mm) | $t_2$ (mm) |
|---|---|---|---|---|---|---|
| (1) | -1. 0 | 15. 0 | 7. 5 | 15. 0 | 30. 0 | 0. 0 |
| (2) | -0. 5 | 18. 8 | 6. 7 | 13. 6 | 50. 0 | 5. 0 |
| (3) | -1. 5 | 13. 9 | 7. 2 | 17. 0 | 26. 0 | -9. 0 |

Provided, in Table 1, $t_1$ and $t_2$ are the lengths from the respective lenses to a plane at which the transfer lenses TF1 and TF2 respectively transfer the coma-free plane.

As described in the foregoing, with respect to the configuration of transfer lenses in a coma-free plane transfer portion, the present invention enables flexible arrangement and electro-optic fine adjustment with a two-lens system. Further, when using three lenses, the present invention provides means that adjusts a spherical aberration correction strength while keeping the 4f system fixed and with a transfer magnification independent thereof.

In this connection, although restrictive conditions of the transfer lens portion are described with respect to a coma-free transfer in the above description, the present invention can also be applied under a condition which transfers two similar specific planes (planes limited by a specimen plane and a transfer condition; the coma-free plane in the above description). Conditions other than a coma-free plane transfer include, for example, minimization of a fifth-order spherical aberration. In this case, it is sufficient to consider a transfer by substituting a plane that serves as a minimum plane of a fifth-order aberration (for example, center of objective lens) for the coma-free plane in the above description.

As the spherical aberration correction portion in the above description, a spherical aberration correction portion that uses hexapole lenses based on the configurations of H. Rose and M. Haider is described. However, it is also possible to provide a spherical aberration correction portion that uses other multi-stage multipole lenses instead of using hexapole lenses. In this case also, the consideration for transferring an image from the objective lens to the spherical aberration correction portion with specific restrictive conditions is the same, and it is also the same that the adjustment of a transfer lens portion comprising an ordinary spherical lens is easier than adjustment of a spherical aberration correction portion comprising multiple poles. The conditions in this case are also the same as in the case of hexapole lenses.

**Claims**

1. An aberration corrector for a transmission electron microscope that is disposed downstream of an objective lens of a transmission electron microscope and that performs a spherical aberration correction by offsetting a spherical aberration of the objective lens with a negative spherical aberration that is generated at a combination lens including a plurality of multipole lenses, comprising:

    a spherical aberration correction portion that generates a negative spherical aberration; and
    a transfer portion that is provided between the objective lens and the spherical aberration correction portion, and that has a first and a second spherical transfer lens that suppress an occurrence of a coma aberration or a fifth-order aberration;

    wherein:

    the transfer portion transfers a coma-free plane or a minimum plane of a fifth-order aberration of the objective lens that is formed in the vicinity of a back focal plane of the objective lens to a coma-free plane of the spherical aberration correction portion or a center plane of a first lens of the spherical aberration correction portion, and causes an electron beam that is scattered at a specimen and emanates from a specimen plane to be incident in parallel with the spherical aberration correction portion; and
    among the two spherical transfer lenses of the coma-free plane transfer portion, a length between the objective lens and the first spherical transfer lens that is arranged at a nearest position to the objective lens is different to a focal length of the first spherical transfer lens.

**2.** The aberration corrector for a transmission electron microscope according to claim 1, wherein focal lengths $f_1$ and $f_2$ of the first and second spherical transfer lenses inside the transfer portion are defined by relational expression (i) below:

[Expression 1]

$$f_1 = \frac{l_2(2l_1 + l_2 \pm K)}{2L}$$
$$f_2 = \frac{l_2(2l_3 + l_2 \mp K)}{2L}$$
(i)

where, $l_1$, $l_2$, and $l_3$ denote a length between the coma-free plane of the objective lens or a center plane of the objective lens and the first spherical transfer lens, a length between the first spherical transfer lens and the second spherical transfer lens, and a length between the second spherical transfer lens and a coma-free plane of the spherical aberration correction portion or a center plane of a first lens of the spherical aberration correction portion, respectively, $L_t$ denotes a total length ($L_t = l_1 + l_2 + l_3$) of the transfer portion, and K is a parameter defined by expression (ii)

[Expression 2]

$$K = \sqrt{l_2^2 - 4l_1 l_3} \quad , \quad l_1 \neq f_1 \text{、} \quad l_3 \neq f_2$$
(ii)

**3.** The aberration corrector for a transmission electron microscope according to claim 2, wherein:

the spherical aberration correction portion includes a first and a second hexapole lens that are mutually equivalent, and a third and a fourth spherical lens that are mutually equivalent for transferring an image and that are disposed between the first and second hexapole lenses; and
when a focal length of the third and the fourth spherical lens is taken as f, an interval between the first hexapole lens and the third spherical lens, an interval between the third spherical lens and the fourth spherical lens, and an interval between the fourth spherical lens and the second hexapole lens are f, 2f, and f, respectively,.

**4.** An aberration corrector for a transmission electron microscope that is disposed downstream of an objective lens of a transmission electron microscope and that performs a spherical aberration correction by offsetting a spherical aberration of the objective lens with a negative spherical aberration that is generated at a combination lens including a plurality of multipole lenses, comprising:

a spherical aberration correction portion that generates a negative spherical aberration; and
a transfer portion that is provided between the objective lens and the spherical aberration correction portion, and that has a first, a second, and a third spherical transfer lens that suppress an occurrence of a coma aberration or a fifth-order aberration, and that enables an adjustment of a transfer magnification to the spherical aberration correction portion from the objective lens by means of the spherical transfer lenses;

wherein:

the transfer portion transfers a coma-free plane or a minimum plane of a fifth-order aberration of the objective lens that is formed in the vicinity of a back focal plane of the objective lens to a coma-free plane of the spherical aberration correction portion or a center plane of a first lens of the spherical aberration correction portion, and causes an electron beam that is scattered at a specimen and emanates from a specimen plane to be incident in parallel with the spherical aberration correction portion; and
among the three spherical transfer lenses of the transfer portion, a length between the objective lens and the first spherical transfer lens that is arranged at a nearest position to the objective lens is different to a focal length of the first spherical transfer lens.

5.  The aberration corrector for a transmission electron microscope according to claim 4, wherein focal lengths $f_1$, $f_2$, and $f_3$ of the first to third spherical transfer lenses inside the transfer portion are defined by the following relational expression (iii) with respect to a transfer magnification $m_t$ of the transfer portion:

[Expression 3]

$$f_1 = \frac{l_2\left(l_1 m_t^2 + l_4\right)}{\left(l_1 + l_2\right)m_t^2 - l_3 m_t + l_4}$$

$$f_2 = -\frac{l_2 l_3 m_t}{l_1 m_t^2 - \left(l_2 + l_3\right)m_t + l_4} \qquad \text{(iii)}$$

$$f_3 = \frac{l_3\left(l_1 m_t^2 + l_4\right)}{l_1 m_t^2 - l_2 m_t + \left(l_3 + l_4\right)}$$

where, $l_1$, $l_2$, $l_3$, and $l_4$ denote a length between the coma-free plane of the objective lens or a center plane of the objective lens and the first spherical transfer lens, a length between the first spherical transfer lens and the second spherical transfer lens, a length between the second spherical lens and the third spherical transfer lens, and a length between the third spherical transfer lens and a coma-free plane of the spherical aberration correction portion or a center plane of a first lens of the spherical aberration correction portion, respectively.

6.  The aberration corrector for a transmission electron microscope according to claim 5, wherein, when taking a magnitude of the objective lens to be $m_0$ and selecting a transfer magnification $m_t$ of the transfer portion while maintaining a transfer condition represented in the expression (iii), offsetting between a spherical aberration $C_{SO}$ of the objective lens and a negative spherical aberration $C_{SC}$ that is generated by the spherical aberration correction portion to correct the spherical aberration $C_{SO}$ is adjusted according to relational expression (iv)

[Expression 4]

$$C_{so} + \left(m_0 m_t\right)^{-4} C_{sc} \equiv 0 \qquad \text{(iv)}$$

7.  The aberration corrector for a transmission electron microscope according to claim 6, wherein, in a case in which the relation $l_1 = l_2 = l_3 = l_4 \equiv L$ exists for $l_1$, $l_2$, $l_3$, and $l_4$, when the first to third spherical transfer lenses have focal lengths $f_{10}$, $f_{20}$, and $f_{30}$ that are references shown in expression (v), respectively,

[Expression 5]

$$f_{10} = L/2$$
$$f_{20} = L/4 \qquad \text{(v)}$$
$$f_{30} = L/2$$

the transfer magnification $m_t$ = -1 is obtained, and fine adjustment of a transfer magnification is enabled by changing the focal lengths of the first and third spherical transfer lenses as shown in expression (vi)

[Expression 6]

$$f_1 = \frac{L}{2}\left\{1 + \frac{\delta m}{4}\right\}$$
$$f_3 = \frac{L}{2}\left\{1 - \frac{\delta m}{4}\right\}$$

(vi)

as antisymmetries to obtain $m_t = -1 + \delta m$

FIG. 1

FIG. 2

EP 2 107 590 A2

# FIG. 3

EP 2 107 590 A2

FIG. 4

EP 2 107 590 A2

## FIG. 5

FIG. 6

FIG. 7

FIG. 8

(1) $m_t = -1.0$

(2) $m_t = -0.5$

(3) $m_t = -1.5$

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008092691 A
- JP 3207196 B, H. Rose

- JP 2002510431 B

**Non-patent literature cited in the description**

- **M. Haider ; S. Uhlemann ; J. Zach.** Upper limits for the residual aberrations of a high- resolution aberration-corrected STEM. *Ultramicroscopy,* 2000, vol. 81, 163

- **O. L. Krivanek ; P. D. Nellist ; N. Dellby ; M. F. Murfitt ; Z. Szilagyi.** Towards sub-0.5 A electron beams. *Ultramicroscopy,* 2003, vol. 96, 229